# EUROPÄISCHE PATENTSCHRIFT

(11) **EP 1 430 547 B1**
(45) Veröffentlichungstag und Bekanntmachung des Hinweises auf die Patenterteilung: **09.04.2008**
(21) Anmeldenummer: 02779401.5
(22) Anmeldetag: 20.09.2002
(51) Int. Cl.: H01L 41/09

(54) **PIEZOMOTOREN MIT IN EINEM RESONATOR ANGEORDNETEN PIEZOELEMENT**
PIEZOELECTRIC MOTOR COMPRISING A PIEZOELECTRIC ELEMENT ARRANGED IN A RESONATOR
MOTEURS PIEZOELECTRIQUES POURVUS D'ELEMENTS PIEZOELECTRIQUES ARRANGES DANS UN RESONATEUR

(30) Priorität: 21.09.2001 DE 10146704
(43) Veröffentlichungstag der Anmeldung: 23.06.2004
(73) Patentinhaber: Elliptec Resonant Actuator AG, 44379 Dortmund (DE)
(72) Erfinder: MAGNUSSEN, Björn Dr., 58640 Iserlohn (DE); HAGEMANN, Benjamin, 44229 Dortmund (DE); SCHULER, Dieter, 44137 Dortmund (DE); DAVIDSON, Erick, El Cerrito, CA 94530 (US)
(74) Vertreter: Bittner, Bernhard
(86) Internationale Anmeldenummer: PCT/EP2002/010624
(87) Internationale Veröffentlichungsnummer: WO 2003/028121

(56) Entgegenhaltungen:
- EP-A- 0 293 918
- EP-A- 1 089 351
- WO-A-01/24287
- WO-A-01/45138
- DE-A- 19 928 780
- US-A- 6 114 798

## Beschreibung

Die vorliegende Erfindung betrifft einen Piezomotor mit mindestens einem Piezoelement und mindestens einem Resonator, wobei mindestens eine Fläche des Piezoelementes und mindestens eine Fläche des Resonators miteinander verbunden sind. Des weiteren betrifft die Erfindung mehrere Verfahren zur Herstellung des erfindungsgemäßen Piezomotors.

Piezomotoren stellen ein alternatives Antriebskonzept zu kleinen elektromagnetischen Motoren dar, die in der Regel zu laut und/oder zu teuer sind. Diese Piezomotoren weisen mindestens ein Piezoelement auf, das sich unter dem Einfluß von elektrischer Spannung reversibel ausdehnt, so daß bei Wechselspannung eine Schwingung erzeugbar ist, die beispielsweise auf den Resonator übertragen wird. Da die Ausdehnung des Piezoelementes in der Regel nur einige µm oder weniger beträgt, müssen die Piezoelemente gemäß dem Stand der Technik sehr glatte Oberflächen aufweisen, die in der Regel außerdem noch exakt parallel zueinander sein müssen. Diese Oberflächen lassen sich bei einem Piezoelement, das beispielsweise nach dem Herstellungsverfahren für Keramikkondensatoren (im folgenden Keramikkondensatorverfahren) produziert worden ist, nur durch Schleifen der Oberflächen erzielen. Dieses Schleifen der Oberflächen ist jedoch sehr aufwendig und mit einem enormen Ausschuß verbunden, so daß Piezomotoren mit derartigen Piezoelementen großtechnisch nur bedingt von Interesse sind.

Aus der DE 199 287 080 A1 ist ein Stellantrieb mit einem piezoelektrischen Aktor bekannt. Dieser piezoelektrische Aktor weist eine obere Kontaktfläche auf, die an einer Kopfplatte aufliegt, sowie eine untere Kontaktfläche, die an einer Fußplatte aufliegt. Dabei werden die Endflächen des Piezoelementes und die Kopf- bzw. Fußplatten mit einem Füllstoff ausgefüllt.

Es stellte sich deshalb die Aufgabe, einen Piezomotor zur Verfügung zu stellen, der die Nachteile des Standes der Technik nicht aufweist.

Gelöst wird diese Aufgabe erfindungsgemäß durch einen Piezomotor mit mindestens einem Piezoelement und mindestens einem Resonator, wobei mindestens eine Fläche des Piezoelementes und mindestens eine Fläche des Resonators miteinander verbunden sind und die Formgebung des Piezoelementes im Grünzustand erfolgt und seine Flächen nach dem Sintern nicht mehr geglättet werden.

Die erfindungsgemäß eingesetzten Piezoelemente werden beispielsweise nach dem sogenannten Keramikkondensatorverfahren hergestellt. Dabei wird zunächst eine Mischung bestehend aus einem Keramikpulver, einem Binder und Additiven hergestellt, die dann auf einen Film aufgezogen wird. Dieser Film wird anschließend in einzelne Schichten zerschnitten und mit den Elektroden, die sich zwischen zwei Keramikschichten befinden, bedruckt. Diese bedruckten Keramikschichten werden sodann gestapelt und miteinander verpreßt. Aus diesen Stapeln werden anschließend die jeweiligen Piezoelemente herausgeschnitten, die sich in dem sogenannten Grünzustand befinden, d. h. noch nicht gesintert worden sind. Nach dem Ausschneiden werden die Stapel zunächst einmal erwärmt, um die Piezoelemente von dem Binder zu befreien. In einem weiteren Ofen werden die Piezoelemente dann bei Temperaturen von vorzugsweise > 800 °C gesintert. Abschließend werden gegebenenfalls noch die Kanten der Piezoelemente, beispielsweise in einer rotierenden Trommel, abgeschlagen. Dieses Verfahren ist beispielsweise in Technical Information Multilayer Ceramic Capacitors -Materials And Manufacture, Manfred Kahn, AVX Corporation, Myrtle Beach, SC, USA, beschrieben.

Die aus diesem Herstellungsverfahren resultierenden Piezoelemente haben Oberflächen, die Unebenheiten aufweisen. Des weiteren sind die Flächen der vorzugsweise quaderförmigen Piezoelemente nicht exakt parallel zueinander. Erfindungsgemäß werden diese Flächen vor dem Einbau in den Piezomotor nicht mehr geglättet. Es muß als überaus erstaunlich und für den Fachmann völlig unerwartet gelten, daß es gelingt, mit derartigen Piezoelementen Piezomotoren herzustellen, die reproduzierbare Schwingungseigenschaften aufweisen.

Die erfindungsgemäßen Piezomotoren sind einfach herzustellen. Dadurch, daß der Ausschuß an Piezoelementen reduziert wird, ist die Abfallmenge bei der Herstellung des erfindungsgemäßen Piezomotors auch vergleichsweise gering.

Erfindungsgemäß ist das Piezoelement durch mindestens eine Fläche mit dem Resonator verbunden. In einer bevorzugten Ausführungsform ist das Piezoelement durch mindestens zwei Flächen mit dem Resonator verbunden. Der Verbund kann form-, kraft- und/oder stoffschlüssig sein. Vorzugsweise ist der Verbund jedoch nicht auf der gesamten Fläche, sondern nur auf Teilflächen form-, kraft- und/oder stoffschlüssig. Besonders bevorzugt ist der Verbund auf den Teilflächen nur kraftschlüssig.

In einer vorteilhaften Ausgestaltung der Erfindung erfolgt der Verbund zwischen dem Piezoelement und dem Resonator ohne zusätzliche Füllstoffe, wie etwa Kleber, Epoxidharz, Gummi, Kunsstoff oder dergleichen. Ebenso vorteilhaft erfolgt der Verbund ohne Verwendung von Distanzstücken oder anderen Montagehilfen, beispielsweise aus Keramik, Metall oder ähnlichen , dem Fachmann geläufigen Werkstoffen.

Erfindungsgemäß weisen die Piezoelemente auf ihren äußeren Flächen Unebenheiten oder Rauhigkeiten auf. Diese Unebenheiten oder Rauhigkeiten sind vorzugsweise > 1 µm, besonders bevorzugt > 10 µm und ganz besonders bevorzugt > 100 µm.

Das Piezoelement kann jede beliebige dem Fachmann geläufige Form aufweisen. In einer bevorzugten Ausführungsform ist das Piezoelement jedoch im wesentlichen platten-, zylinder- oder quaderförmig und weist mindestens zwei gegenüberliegende Seiten, vorzugsweise zwei gegenüberliegende Kontaktflächen, auf, die nicht exakt parallel zueinanderliegende ebene Flächen sind.

Der Resonator weist in einer bevorzugten Ausgestaltung der Erfindung eine im wesentlichen zweidimensionale Form auf, wobei sich die Geometrie des Resonators in einer Raumrichtung, die im wesentlichen senkrecht auf den von den Hauptflächen aufgespannten Ebenen steht, nicht verändert. Der Fachmann versteht aber, dass das Prinzip der Zweidimensionalität dabei ebenfalls verwirklicht ist, wenn geringfügige Abweichungen, beispielsweise durch Abschrägungen oder Abrundungen von Kanten oder Eckbereichen, eingebracht sind.

Der erfindungsgemäße Piezomotor weist ein sehr gut reproduzierbares Schwingungsverhalten auf. Wird das Piezoelement zu einer gewissen Schwingung angeregt und diese Schwingung auf den Resonator übertragen, beträgt die Standardabweichung der optimalen Betriebsfrequenz vorzugsweise < 20%, besonders bevorzugt < 5%, ganz besonders bevorzugt < 1,5% am meisten bevorzugt < 0,6% und am allermeisten bevorzugt < 0,1%, bezogen auf die gemittelten Betriebsfrequenzen der in Serienproduktion gefertigten Motoren gleicher Bauweise. Wird das Piezoelement zu einer gewissen Schwingung angeregt und diese Schwingung auf den Resonator übertragen, beträgt die Standardabweichung der resultierenden Amplitude des Resonators vorzugsweise 60%, besonders bevorzugt < 40%, ganz besonders bevorzugt < 15% und am meisten bevorzugt < 5%, bezogen auf die mittlere Betriebsamplitude aller in Serienproduktion gefertigten Motoren.

Der Piezomotor kann eine beliebige Größe und dementsprechend eine beliebige maximale Längenänderung aufweisen. Vorzugsweise beträgt jedoch die maximale Längenänderung des Piezoelementes < 10 µm, besonders bevorzugt < 2 µm, ganz besonders bevorzugt < 0,5 µm und am meisten bevorzugt < 0,1 µm.

In einer bevorzugten Ausführungsform der vorliegenden Erfindung sind die Flächen des Piezoelementes und/oder die Flächen des Resonators, über die der Verbund zwischen dem Piezoelement und dem Resonator erzeugt wird, geneigt, um den Einbau des Piezoelementes in den Resonator zu vereinfachen bzw. um eine klar definierte Kontaktfläche zwischen Resonator und Piezoelement zu erzeugen.

In einer anderen bevorzugten Ausführungsform ist an wenigstens einer der Flächen des Piezoelementes und/oder des Resonators, über die der Kontakt zwischen Piezoelement und Resonator erzeugt wird, mindestens eine Ausbuchtung angeordnet, die eine klar definierte Kontaktfläche zwischen Piezoelement und Resonator darstellt. Diese Ausbuchtung ist vorzugsweise nicht in der Mitte der zugehörigen Kontaktfläche des Resonators und/oder Piezoelementes.

Vorzugsweise wird die Lage der Fläche, mit der das Piezoelement an dem vorzugsweise stabförmigen Resonator anliegt, gemäß der Formel B/(A-B/2) < 1, vorzugsweise < 0,3, ermittelt, wobei B die Breite der Anlagefläche und A der maximale Abstand von der neutralen Faser ist. Die neutrale Faser ist die Linie in dem Resonator, deren Spannung bei einer reinen Biegebelastung null ist.

Weiterhin bevorzugt ist die Fläche des Piezoelementes und/oder die Fläche des Resonators, über die der Kontakt zwischen Piezoelement und Resonator zustande kommt, zumindestens teilweise konvex geformt.

Das Piezoelement des erfindungsgemäßen Piezomotors weist vorzugsweise eine monolithische Vielschichtbauweise auf, wobei die Elektroden vorzugsweise schichtweise zwischen zwei Keramikschichten in dem Piezoelement angeordnet sind. In einer besonders bevorzugten Ausgestaltung der Erfindung bestehen die Elektroden zumindest im wesentlichen aus Kupfer.

In einer weiteren bevorzugten Ausgestaltung der Erfindung weist das Piezoelement zwei Terminals auf, über die wenigstens ein elektrisches Signal in das Piezoelement übertragbar ist, auf. Als Terminal wird hierbei die Verbindung zwischen der elektrischen Leitung, über die das Signal von der Erregerquelle zu dem Piezomotor geleitet wird, und dem Piezoelement verstanden. In einer ganz besonders bevorzugten Ausgestaltung der Erfindung wird dem Piezoelement ein erstes Signal übermittelt und das Piezoelement zu einer ersten Schwingung in einem ersten Modus angeregt. Hierdurch erfolgt die Schwingung der Kontaktfläche des Resonators in eine erste Richtung. Analog hierzu wird bei Übermittlung eines zweiten elektrischen Signals an das piezoelektrische Bauelement die Kontaktfläche des Resonators zur Schwingung in eine zweite Richtung angeregt.

Die Kontaktfläche führt die für den jeweiligen Antrieb des anzutreibenden Körpers benötigten makroskopischen Bewegungen aus, so daß es für dessen Antrieb keiner zusätzlichen Mechanismen oder Bauteile bedarf. In einer bevorzugten Ausgestaltung der Erfindung weist der Resonator genau eine Kontaktstelle zu dem anzutreibenden Körper auf.

In einer bevorzugten Ausgestaltung der Erfindung wird ein durch den Piezomotor bewegte Vorrichtung bei zwei unterschiedlichen an das Piezoelement übertragenen Signalen in zwei unterschiedliche Richtungen bewegt. In einer besonders vorteilhaften Ausgestaltung der Erfindung wird das bewegte Element hierbei in zwei entgegengesetzte Richtungen angetrieben.

Das elektrische Signal ist dabei vorzugsweise ein sinoidales oder Rechtecksignal. Jedoch ist keine Erzeugung eines im wesentlichen sägezahnförmigen Erregersignals notwendig.

Der erfindungsgemäße Piezomotor wird vorzugsweise in der Nähe einer seiner Resonanzfrequenzen betrieben. Weiterhin bevorzugt können mit einem Piezoelement und nur jeweils einer elektrischen Anregung bei zwei unterschiedlichen Frequenzen zwei Bewegungen des Resonators und damit zwei entgegengesetzte Bewegungen der angetriebenen Vorrichtung erzeugt werden.

In einer bevorzugten Ausführungsform ist das Piezoelement so gestaltet, daß seine Breite die Breite der Kontaktfläche des Resonators übersteigt, so daß das Piezoelement zumindestens auf einer Seite, vorzugsweise auf beiden Seiten, des Resonators, hinausragt. Vorzugsweise ist die Breite des Piezoelementes 1,1 bis 10 mal besonders bevorzugt 3 bis 5 mal größer als die Breite der Kontaktfläche des Resonators.

In einer weiteren bevorzugten Ausführungsform des erfindungsgemäßen Piezomotors weist das Piezoelement lediglich im Bereich der Außenelektroden Isolationszonen auf. Diese Ausführungsform hat den Vorteil, daß weniger piezoelektrisches Material zur Herstellung der Piezoelemente benötigt wird. Weiterhin hat dieser Piezomotor den Vorteil, daß die Randzonen des Piezoelementes, die sich nicht oder nur vermindert unter Anlegen einer elektrischen Spannung ausdehnen, reduziert wird. Ein weiterer Vorteil des erfindungsgemäßen Motors besteht darin, daß ein Piezoelement, das lediglich im Bereich der Außenelektroden Isolationszonen aufweist, bei Anlegen einer elektrischen Spannung eine im wesentlichen zweidimensionale Ausdehnung vollführt.

Der erfindungsgemäße Piezomotor kann jedes beliebige Piezoelement aufweisen, bei dem zumindest die Kontaktfläche zwischen Piezoelement und Resonator nach dem Sintern nicht geglättet worden ist. Vorzugsweise ist das Piezoelement jedoch in monolithischer Vielschichtbauweise aus einem Stapel aus mindestens zwei Keramikschichten und jeweils einer zwischen zwei Keramikschichten angeordneten Elektrodenschicht gefertigt. Vorzugsweise erfolgt die Fertigung dieses Vielschichtpiezoelementes nach dem Keramikkondensatorherstellungsverfahren.

Weiterhin bevorzugt weist das Piezoelement des erfindungsgemäßen Piezomotors nur eine oder aber keine Außenelektroden auf. Die Funktion der Außenelektroden wird vielmehr durch den Resonator übernommen. Dies kann dadurch erreicht werden, daß die Elektroden zwischen den Keramikschichten zumindest an einer der Flächen des Resonators in direktem Kontakt zu dem Resonator stehen, der in diesem Fall aus elektrisch leitendem Material, vorzugsweise aus Metall, besonders bevorzugt Kupfer oder ein im wesentlichen Kupferhaltiges Metall sein muß. Diese Ausführungsform ist besonders einfach und besonders kostengünstig herzustellen. Gegebenenfalls wird zwischen den Resonator und das Piezoelement noch ein elektrisch leitendes Füllmaterial eingebracht, um den elektrischen Kontakt zu gewährleisten.

Vorzugsweise wird das Piezoelement so in den Resonator eingepreßt, daß sich der Resonator zumindestens in Teilbereichen elastisch und/oder plastisch, vorzugsweise plastisch, verformt und sich dadurch zumindestens teilweise den Unebenheiten des Piezoelementes anpaßt. Vorzugsweise beträgt die Vergleichsspannung in dem Resonator in dem Kontaktbereich mit dem Piezo zumindest lokal > 100 N/mm², besonders bevorzugt > 250 N/mm² und am meisten bevorzugt > 300 N/mm².

Bei dem erfindungsgemäßen Piezomotor ist es sogar oftmals vorteilhaft das piezoelektrische Bauelement im eingebauten Zustand oder während des Betriebes einer gezielten Biegebeanspruchung auszusetzen. Das piezoelektrische Bauelement des erfindungsgemäßen Motors kann mit größeren Maßtoleranzen gefertigt werden.

Der erfindungsgemäße Piezomotor hat den Vorteil, daß er einfach und günstig herzustellen ist und daß bei seiner Produktion nur wenig Ausschuß anfällt. Insbesondere können Piezoelemente verwendet werden, die nicht einem aufwändigen Glättungsprozess unterzogen worden sind.

Ein weiterer Gegenstand der vorliegenden Erfindung ist ein Verfahren zur Herstellung des erfindungsgemäßen Piezomotors, bei dem das Piezoelement erst nach dessen Einbau in den Resonator polarisiert wird. Der Einbau kann durch Form-, Kraft- oder Stoffschluß erfolgen.

Dieses Verfahren hat den Vorteil, daß das Piezoelement beim Einbau eine vergleichsweise kleine Ausdehnung aufweist und deshalb leichter einzupressen ist.

Ein weiterer Gegenstand der vorliegenden Erfindung ist ein Verfahren zur Herstellung des erfindungsgemäßen Piezomotors, bei dem das Piezoelement vor dessen Einbau in dem Resonator depolarisiert wird. Der Einbau kann durch Form-, Kraft- oder Stoffluß erfolgen.

Dieses Verfahren hat den Vorteil, daß das Piezoelement beim Einbau eine vergleichsweise kleine Ausdehnung aufweist und deshalb leichter einzupressen ist.

Ein zusätzlicher Gegenstand der vorliegenden Erfindung ist ein Verfahren zur Herstellung des erfindungsgemäßen Piezomotors, bei dem das Piezoelement zumindest während dessen Einbau in den Resonator kurzgeschlossen wird.

Dieses Verfahren hat den Vorteil, daß das Piezoelement beim Einbau eine vergleichsweise kleine Ausdehnung aufweist und deshalb leichter einzupressen ist. Im übrigen ist das Piezoelement vergleichsweise weich und deshalb leichter einzupressen.

Ein weiterer Gegenstand der vorliegenden Erfindung ist ein Verfahren zur Herstellung des erfindungsgemäßen Piezomotors, bei dem das Piezoelement vor dessen Einbau in den Resonator polarisiert und dann mit einer im Vergleich zur Polarisierung negativen elektrischen Spannung beaufschlagt wird.

Dieses Verfahren hat den Vorteil, daß das Piezoelement beim Einbau eine vergleichsweise kleine Ausdehnung aufweist und deshalb leichter einzupressen ist. Im übrigen ist das Piezoelement vergleichsweise weich und deshalb leichter einzupressen.

Im folgenden wird die Erfindung anhand der Figuren 1 bis 7 erläutert. Diese Erläuterungen sind lediglich beispielhaft und schränken den allgemeinen Erfindungsgedanken nicht ein. Der Fachmann erkennt, daß die Darstellung lediglich schemenhaft sind.
**Figur 1** zeigt eine Resonator/Piezoelement-Paarung.
**Figuren 2 A bis 2 F** zeigen unterschiedliche Ausgestaltungsformen der Kontaktfläche des Piezoelementes bzw. des Resonators.
**Figur 3** zeigt einen Resonator mit Ausbuchtungen.
**Figur 4** zeigt eine Resonator/Piezoelement-Paarung, bei der die Breite des Piezoelementes größer ist als die Breite des Resonators.
**Figur 5** zeigt eine Keramikschicht, die nur im Bereich der Außenelektroden lsolationszonen aufweist.
**Figur 6** zeigt einen Resonator mit Ausbuchtungen
**Figuren 7a** **- c** zeigen unterschiedliche Ausgestaltungsformen der Kontaktfläche des Resonators

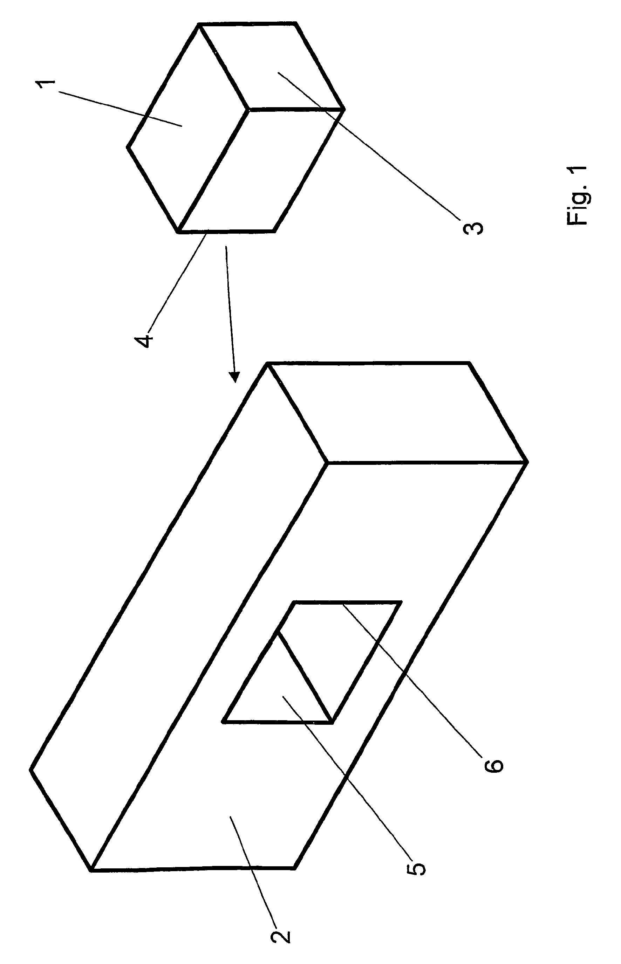

**Figur 1** zeigt ein Piezoelement 1, das nach dem Keramikkondensatorverfahren hergestellt worden ist. Dieses Piezoelement weist zwei Flächen 3, 4 auf, mit denen das Piezoelement mit den Flächen 5, 6 des Resonators zumindest teilweise formschlüssig in Kontakt steht. Die Flächen 3, 4 weisen Unebenheiten auf und/oder sind nicht parallel zueinander angeordnet. Das Piezoelement wird in die Aussparung des Resonators eingepreßt.

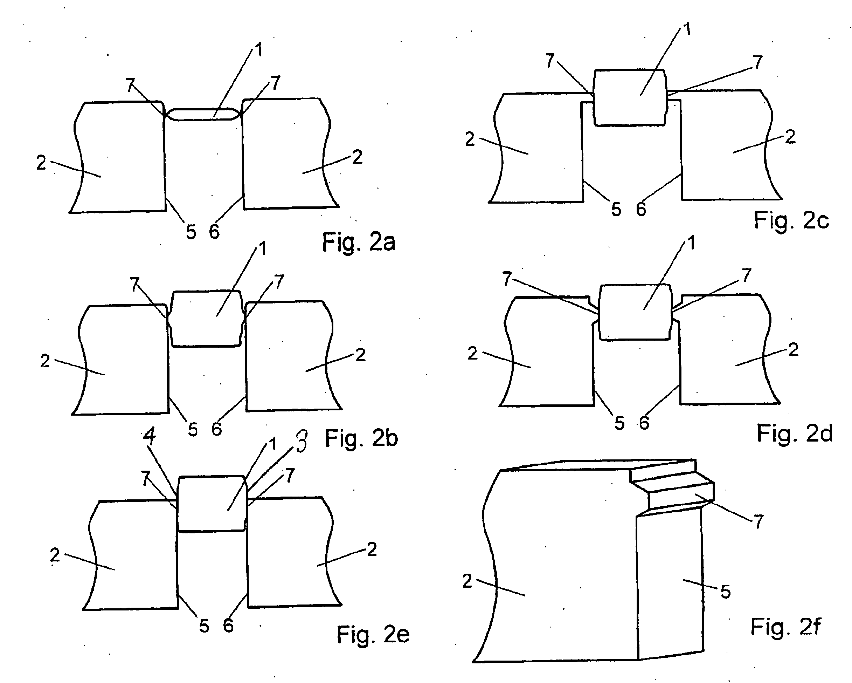

**Die** **Figuren 2 A bis 2 F** zeigen schematische Schnitte durch unterschiedliche Ausgestaltungsformen der Kontaktflächen des Piezoelementes bzw. des Resonators, die einen Einbau eines Piezoelementes mit unregelmäßigen Kontaktflächen 3, 4 erlauben. Der Fachmann erkennt, daß die jeweiligen Teile des Resonators außerhalb der Schnittebene miteinander verbunden sind. Die geschwungen Linien rechts und links an dem Resonator sollen Bruchkanten symbolisieren.

**In** **Figur 2 A** ist das Piezoelement 1 sehr schmal gestaltet und im Außenbereich zugespitzt. Des weiteren weisen die Flächen 5, 6 Ausbuchtungen 7 auf, so daß sich das Piezoelement und der Resonator lediglich entlang einer gegebenenfalls unterbrochenen Linie berühren.

**Figur 2 B** zeigt eine Ausführungsform der vorliegenden Erfindung, bei der das Piezoelement Ausbuchtungen 7 aufweist, deren Oberfläche in Kontakt zu den Flächen 5, 6 des Resonators stehen. Die Ausbuchtungen 7 sind mit den Flächen 5, 6 verpreßt. Durch diese Ausführungsform der vorliegenden Erfindung ergibt sich eine klar definierte Kontaktfläche zwischen dem Piezoelement und dem Resonator.

**Figur 2 C** entspricht im wesentlichen Figur 2 B, nur daß in dem vorliegenden Fall die Ausbuchtungen 7 an dem Resonator angeordnet sind. Weiterhin erkennt der Fachmann, daß die Oberfläche des Piezoelementes im Bereich der Kontaktflächen mit dem Resonator leicht konvex gestaltet sind.

**Figur 2 D** entspricht im wesentlichen Figur 2 C, nur daß in dem vorliegenden Fall die Ausbuchtungen in den Flächen 5, 6 wie in **Figur 2 F** gestaltet sind. Diese Formgebung erleichtert auch das Einsetzen des Piezos in den Resonator.

**Figur 2 E** zeigt den Verbund zwischen einem Resonator und einem Piezoelement, das konvexe Flächen 3, 4 aufweist. In dieser Bauform wird die Lage der Kontaktfläche durch die versetzte Anordnung von Piezoelement relativ zum Resonator begrenzt.

**Figur 2** **F** zeigt eine spezielle Ausgestaltungsform der Ausbuchtung 7. Die Ausbuchung weist an ihrer Spitze eine plane Fläche auf, an der das Piezoelement anliegt.

Der Fachmann erkennt aus den Darstellungen gemäß den Figuren 2 A - F, daß die Ausbuchtungen 7 asymmetrisch an dem Resonator angeordnet sein können und daß das Piezoelement nicht horizontal in dem Resonator angeordnet sein kann.

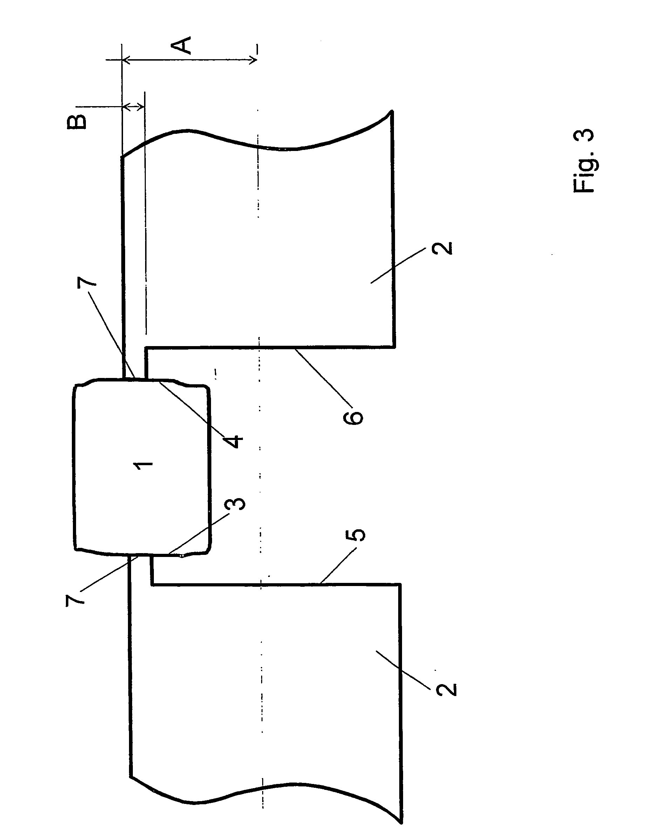

**Figur 3** zeigt eine weitere Gestaltungsform des erfindungsgemäßen Piezomotors. Die Flächen 3, 4 des Piezoelementes 1 stehen in direktem Kontakt mit den Ausbuchtungen 7, die in den Resonatorflächen 5, 6 angeordnet sind. Die Breite der Ausbuchtungen ist mit B vermaßt, der maximale Abstand der Ausbuchtung von der neutralen Phase, die im vorliegenden Fall in der Mitte des Resonators liegt, ist mit A vermaßt.

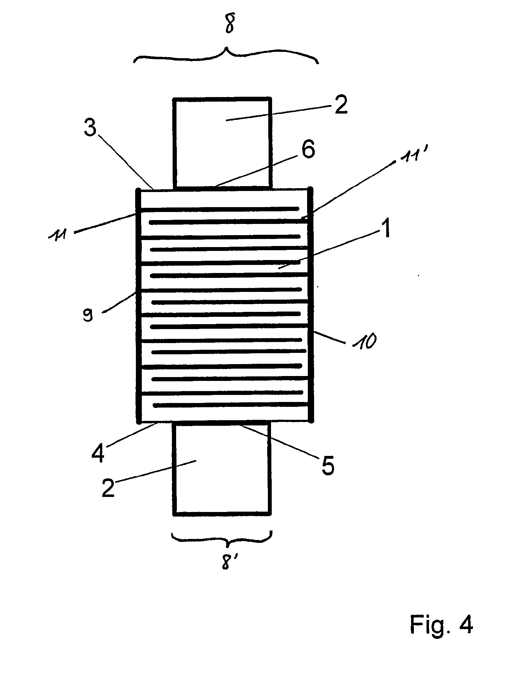

**Figur 4** zeigt ein Schnittbild entlang der Motorsymmetrieebene einer Ausführungsform des erfindungsgemäßen Piezomotors, bei dem das Piezoelement 1 eine größere Breite 8 aufweist als die Breite 8' des Resonators 2. In dem Piezoelement 1 sind die einzelnen Elektrodenschichten 11, 11' dargestellt. Diese Ausführungsform des erfindungsgemäßen Piezomotors hat den Vorteil, daß lediglich der mittlere Bereich des Piezoelementes mit dem Resonator zusammenwirkt und daß die Außenbereiche, in denen sich die lsolationszonen befinden, die einen Kurzschluß zwischen den Außenelektroden 9,10 und den Elektrodenschichten vermeiden, nicht mit dem Resonator direkt zusammenwirken.

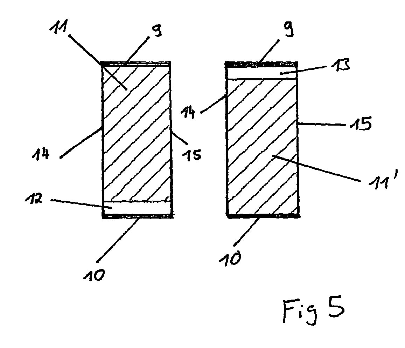

**Figur 5** zeigt zwei Keramikschichten und die dazugehörige Elektrodenschicht 11, 11', die schraffiert dargestellt sind. Jeweils versetzt weisen die Keramikschichten Isolationsschichten 12, 13 auf, die einen Kurzschluß zwischen der Keramikschicht 11 und der Außenelektrode 10 bzw. der Elektrodenschicht 11' und der Außenelektrode 9 vermeiden. Der Fachmann erkennt, daß die jeweiligen Schichten in ihren Randbereichen 14, 15 keine Isolationsschichten aufweisen.

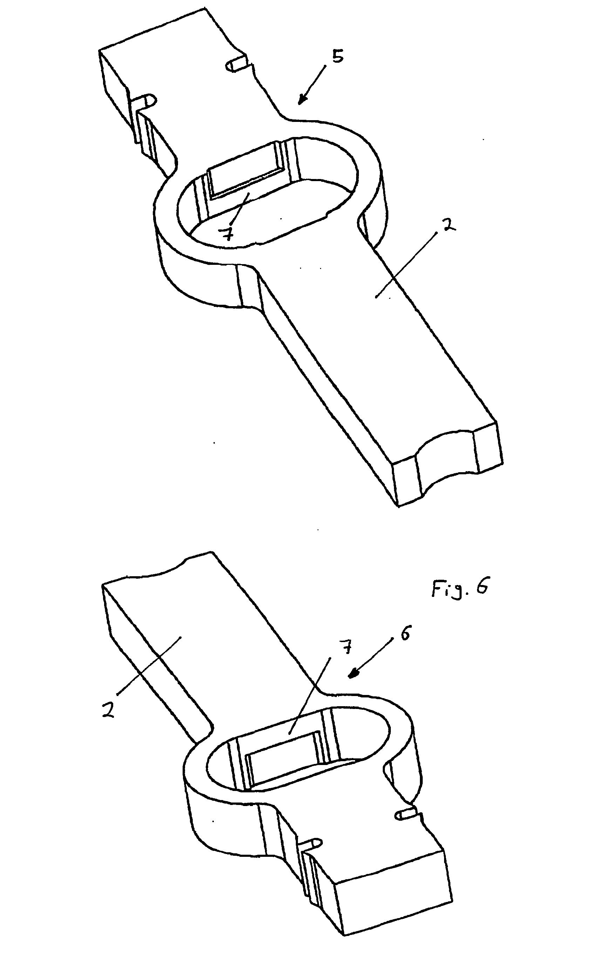

**Figur 6** zeigt einen Resonator 2 in zwei Darstellungen, der in den Flächen 5, 6 Ausbuchtungen 7 aufweist, zwischen die ein Piezoelement (nicht dargestellt) eingebaut wird. In dem vorliegenden Fall werden die Ausbuchtungen dadurch realisiert, daß das um die Ausbuchtungen liegende Material abgetragen wird.

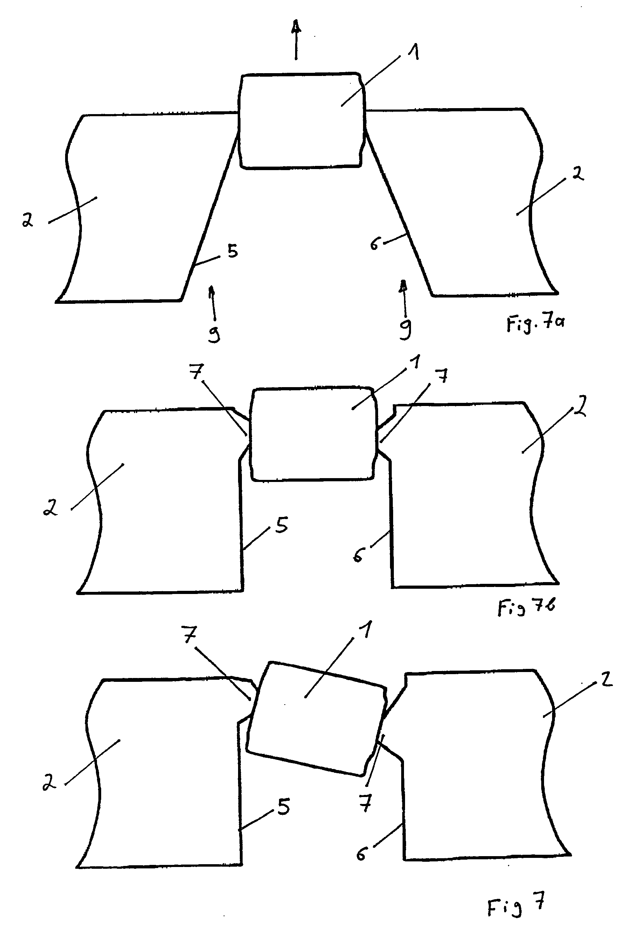

Die Figuren 7 a - c zeigen drei weitere mögliche Gestaltungsformen der Flächen 5, 6 des Resonators. In **Figur 7 a** weisen die Flächen 5, 6 jeweils eine Neigung 9 auf, was den Einbau des Piezoelementes vereinfacht. Für den Einbau wird das Piezoelement von unten nach oben in den Resonator geschoben, was durch den Pfeil symbolisiert wird. **Figur 7b** zeigt einen Resonator 2 mit zwei Ausbuchtungen 7. Die Ausbuchtungen sind in ihrer vertikalen Anordnung zueinander verschoben, so daß die linke Ausbuchtung höher sitzt als die rechte Ausbuchtung. Dementsprechend ergeben sich unterschiedliche Angriffspunkte an dem Piezoelement. Das Piezoelement ist jedoch horizontal angeordnet. **Figur 7c** entspricht im wesentlichen der Ausführungsform gemäß Figur 7b, nur daß bei diesem Beispiel das Piezoelement nicht horizontal angeordnet ist.

## Patentansprüche

1. Piezomotor, mit mindestens einem Piezoelement (1) und mindestens einem Resonator (2), wobei die Formgebung des Piezoelementes im Grünzustand erfolgt und seine Flächen (3, 4) nach dem Sintern nicht mehr geglättet werden, **dadurch gekennzeichnet, dass** mindestens zwei Flächen (3, 4) des Piezoelementes (1) und mindestens zwei Flächen (5, 6) des Resonators (2) jeweils direkt ohne zusätzliche Füllstoffe miteinander verbunden sind.

2. Piezomotor nach Anspruch 1, **dadurch gekennzeichnet, dass** das Piezoelement nach dem Produktionsverfahren für Keramikkondensatoren hergestellt wird.

3. Piezomotor nach einem der vorhergehenden Ansprüche, **dadurch gekennzeichnet, dass** der Verbund zwischen den Flächen (3,4) und den Flächen (5, 6) nur teilweise form- oder kraftschlüssig ist.

4. Piezomotor nach einem der vorhergehenden Ansprüche, **dadurch gekennzeichnet, dass** der Verbund zwischen den Flächen (3, 4) und den Flächen (5, 6) nur teilweise stoffschlüssig ist.

5. Piezomotor nach einem der vorhergehenden Ansprüche, **dadurch gekennzeichnet, dass** die Flächen (3, 4) Unebenheiten von > 1 µm, vorzugsweise > 10 µm, besonders bevorzugt> 100 µm aufweisen.

6. Piezomotor nach einem der vorhergehenden Ansprüche, **dadurch gekennzeichnet, dass** das Piezoelement (1) Im wesentlichen platten-, zylinder- oder quaderförmig ist und mindestens zwei gegenüberliegende Seiten des Piezoelementes nicht exakt parallel zueinander liegende, ebene Flächen sind.

7. Piezomotor nach einem der vorhergehenden Ansprüche, **dadurch gekennzeichnet, dass** das Piezoelement (1) zu einer gewissen Schwingung angeregt wird und diese Schwingung aufden Resonator überträgt, **dadurch gekennzeichnet, dass** die Standartabweichung der für den Betrieb gewählten Resonanzfrequenz < 20%, vorzugsweise < 5%, besonders bevorzugt < 1,5% und ganz besonders bevorzugt < 0.6% und am meisten bevorzugt < 0.1 % bezogen auf die mittlere für den Betrieb gewählte Resonanzfrequenz ist.

8. Piezomotor nach einem der vorhergehenden Ansprüche, **dadurch gekennzeichnet, dass** das Piezoelement (1) zu einer gewissen Schwingung angeregt wird und diese Schwingung auf den Resonator überträgt **dadurch gekennzeichnet, dass** die Standartabwelchung der resultierenden Amplitude des Resonators < 60%, vorzugsweise < 40%, besonders bevorzugt < 15% und ganz besonders bevorzugt < 5% bezogen auf die mittlere Amplitude ist.

9. Piezomotoren nach einem der vorhergehenden Ansprüche, **dadurch gekennzeichnet, dass** die maximale Längenänderung des Piezoelementes < 10 µm, vorzugsweise < 2 µm, besonders bevorzugt < 0,5 µm, ganz besonders bevorzugt < 0,1 µm beträgt.

10. Piezomotor nach einem der vorhergehenden Ansprüche, **dadurch gekennzeichnet, dass** das Piezoelement (1) in monolithischer Vieischichtbauweise, vorzugsweise mit parallelen Kupferelektroden, aufgebaut ist.

11. Piezomotor nach einem der vorhergehenden Ansprüche, **dadurch gekennzeichnet, dass** er ein Piezoelement (1) mit zwei Terminals zur Übertragung eines elektrischen Signals von einer Erregerquelle an das Piezoelement (1) aufweist.

12. Piezomotor nach Anspruch 11, **dadurch gekennzeichnet, dass** das Piezoelement (1) durch ein erstes an das Piezoelement (1) übermitteltes elektrisches Signal zur Schwingung in einem ersten Modus und durch ein zweites an das Piezoelement (1) übermitteltes elektrisches Signal zur Schwingung in einem zweiten Modus anregbar ist.

13. Piezomotor nach Anspruch 12, **dadurch gekennzeichnet, dass** das elektrische Signal ein sinoidales oder Rechtecksignal, aber kein sägezahnförmiges Signal ist.

14. Piezomotor nach einem der vorhergehenden Ansprüche, **dadurch gekennzeichnet, dass** ein von dem Piezomotor bewegbares Element bei zwei an das Piezoelement (1) übertragenen Signalen in zwei Richtungen antreibbar ist.

15. Piezomotor nach Anspruch 14, **dadurch gekennzeichnet, dass** das bewegbare Element in zwei entgegengesetzte Richtungen antreibbar ist.

16. Piezomotor nach einem der vorhergehenden Ansprüche, **dadurch gekennzeichnet, dass** die Flächen (3,4) und/oder die Flächen (5, 6) eine Neigung (9) aufweisen.

17. Piezomotor nach einem der vorhergehenden Ansprüche, **dadurch gekennzeichnet, dass** die Flächen (3, 4) und/oder die Flächen (5, 6) mindestens eine Ausbuchtung (7) aufweisen.

18. Piezomotor nach Anspruch 17, **dadurch gekennzeichnet, dass** die Ausbuchtungen (7) nicht mittig angeordnet sind.

19. Piezomotor nach einem der vorherigen Ansprüche, **dadurch gekennzeichnet, dass** die Fläche (3, 4) und/oder die Fläche (5, 6) jeweils zumindest teilweise, vorzugsweise in dem Bereich, in dem das Piezoelement an dem Resonator anliegt, konvex geformt ist.

20. Piezomotor nach einem der vorhergehenden Ansprüche, **dadurch gekennzeichnet, dass** er in der Nähe einer seiner Ronanzfrequenzen betrieben wird und dass mit einem einzigen Piezoelement und nur jeweils einer elektrischen Anregung bei zwei unterschiedlichen Frequenzen zwei Bewegungen des Resonators erzeugbar sind.

21. Piezomotor nach einem der vorhergehenden Ansprüche, **dadurch gekennzeichnet, dass** die Breite (8) der Flächen (3, 4) größer ist als die Breite (8') der Flächen (5, 6).

22. Piezomotor nach Anspruch 22, **dadurch gekennzeichnet, dass** die Breite (8) der Flächen (3, 4) um 1,1-10, vorzugsweise 3-5 fach größer ist als die Breite (8') der Flächen (5, 6).

23. Piezomotor nach einem der vorhergehenden Ansprüche, **dadurch gekennzeichnet, dass** das Piezoelement lediglich im Bereich der Außenelektroden lsolationazonen aufweist.

24. Piezomotor nach einem der vorhergehenden Ansprüche, **dadurch gekennzeichnet, dass** das Piezoelement in monolithischer Vielschichtbauweise aus einem Stapel aus mindestens zwei Keramikschichten und jeweils einer zwischen zwei Keramikschichten angeordneten Elektrodenschichten gefertigt ist

25. Piezomotor nach einem der vorhergehenden Ansprüche, **dadurch gekennzeichnet, dass** die Flächen (5, 6) des Resonators jeweils die Außenelektroden des Piezoelementes sind.

26. Piezomotor nach einem der vorhergehenden Ansprüche, **dadurch gekennzeichnet, dass** das Piezoelement so in den Resonator eingepresst ist, dass sich der Resonator elastisch und plastisch verformt.

27. Piezomotor nach Anspruch 27, **dadurch gekennzeichnet, dass** beim Einpressen die Vergleichsspannungen in dem Resonator im Bereich des Kontaktes mit dem Piezoelement > 100 N/mm², vorzugsweise > 250 N/mm² und ganz besonders bevorzugt > 300 N/mm² betragen.

28. Verfahren zur Herstellung eines Piezomotors gemäß einem der vorhergehenden Ansprüche, **dadurch gekennzeichnet, dass** das Piezoelement erst nach dessen Einbau in den Resonator polarisiert wird.

29. Verfahren zur Herstellung eines Piezomotors gemäß einem der vorhergehenden Ansprüche, **dadurch gekennzeichnet, dass** das Piezoelement vor dessen Einbau in den Resonator depolarisiert ist.

30. Verfahren zur Herstellung eines Piezomtors gemäß einem der vorhergehenden Ansprüche, **dadurch gekennzeichnet, dass** das Piezoelement zumindest während dessen Einbau in den Resonator kurzgeschlossen wird.

31. Verfahren zur Herstellung eines Piezomotors gemäß einem der Ansprüche 1 - 27, **dadurch gekennzeichnet, dass** das Piezoelement vor dessen Einbau in den Resonator potartsiert und dann mit einer im Vergleich zur Polarisierung negativen elektrischen Spannung beaufschlagt wird.

## Claims

1. A piezoelectric motor comprising at least one piezoelectric element (1) and at least one resonator (2), wherein the piezoelectric element is shaped while green and its surfaces (3, 4) are no longer ground after sintering, **characterized in that** at least two surfaces (3, 4) of the piezoelectric element (1) and at least two surfaces (5, 6) of the resonator (2) are directly interlinked without additional filler materials.

2. A piezoelectric motor according to claim 1, **characterized in that** the piezoelectric element is manufactured using the method for producing ceramic capacitors.

3. A piezoelectric motor according to one of the previous claims, **characterized in that** the link between the surfaces (3, 4) and the surfaces (5, 6) is only partially form-fit or force-fit.

4. A piezoelectric motor according to one of the previous claims, **characterized in that** the link between the surfaces (3, 4) and the surfaces (5, 6) is only partially a chemical bond.

5. A piezoelectric motor according to one of the previous claims, **characterized in that** the surfaces (3, 4) have an unevenness of > 1 µm, preferably > 10 µm, particularly preferable > 100 µm.

6. A piezoelectric motor according to one of the previous claims, **characterized in that** the piezoelectric element (1) has essentially the shape of a plate, a cylinder, or a parallelepiped, and has at least two opposing sides that are not mutually exactly parallel flat surfaces.

7. A piezoelectric motor according to one of the previous claims, **characterized in that** the piezoelectric element (1) is excited to a certain vibration and transmits this vibration into the resonator, **characterized in that** the standard deviation of the resonance frequency selected for operation is < 20%, preferably < 5%, particularly preferred < 1.5%, especially preferred < 0.6%, and mostly preferred <0.1 % in relation to the average resonance frequency selected for operation.

8. A piezoelectric motor according to one of the previous claims, **characterized in that** the piezoelectric element (1) is excited to a certain vibration and transmits this vibration into the resonator, **characterized in that** the mean deviation of the resulting resonator amplitude is < 60%, preferably < 40%, particularly preferred <15% and especially preferred < 5% in relation to the average amplitude.

9. Piezoelectric motors according to one of the previous claims, **characterized in that** the maximal elongation of the piezoelectric element is < 10 µm, preferably < 2 µm, particularly preferred < 0.5 µm and especially preferred < 0.1 µm.

10. A piezoelectric motor according to one of the previous claims, **characterized in that** the piezoelectric element (1) has a monolithic multilayer construction, preferably comprising parallel copper electrodes.

11. A piezoelectric motor according to one of the previous claims, **characterized in that** the piezoelectric element (1) has two terminals for the transmission of an electric signal from an excitation source to the piezoelectric element (1).

12. A piezoelectric motor according to claim 11, **characterized in that** the piezoelectric element (1) is excitable to vibrate in a first mode by a first electric signal that is transmitted to the piezoelectric element (1) and further being excitable to vibrate in a second mode by a second electric signal that is transmitted to the piezoelectric element (1).

13. A piezoelectric motor according to claim 12, **characterized in that** the electrical signal is a sinusoidal or square wave signal but not a saw-tooth shaped signal.

14. A piezoelectric motor according to one of the previous claims, **characterized in that** an element that can be driven by the piezoelectric motor is drivable in two directions with two signals that are transmitted to the piezoelectric element (1).

15. A piezoelectric motor according to claim 14, **characterized in that** the driven element is drivable in two opposing directions.

16. A piezoelectric motor according to one of the previous claims, **characterized in that** the surfaces (3, 4) and/or the surfaces (5, 6) have an inclination (9).

17. A piezoelectric motor according to one of the previous claims, **characterized in that** the surfaces (3, 4) and/or the surfaces (5, 6) comprise at least one indentation (7).

18. A piezoelectric motor according to claim 18, **characterized in that** the indentations (7) are not located in the center.

19. A piezoelectric motor according to one of the previous claims, **characterized in that** the surface (3, 4) and/or the surface (5, 6) has at least partially a convex shape preferably in the region where the piezoelectric element abuts on the resonator.

20. A piezoelectric motor according to one of the previous claims, **characterized in that** the motor is operated close to one of its resonance frequencies, wherein two motions of the resonator can be generated at two different frequencies with one single piezoelectric element and only one electric excitation each.

21. A piezoelectric motor according to one of the previous claims, **characterized in that** the width (8) of the surfaces (3, 4) is larger than the width (8') of the surfaces (5, 6).

22. A piezoelectric motor according to claim 21, **characterized in that** the width (8) of the surfaces (3, 4) is larger than the width (8') of the surfaces (5, 6) by a factor 1.1 - 10, preferably 3 - 5.

23. A piezoelectric motor according to one of the previous claims, **characterized in that** the piezoelectric element comprises insulation regions only in the vicinity of the external electrodes.

24. A piezoelectric motor according to one of the previous claims, **characterized in that** the piezoelectric element has a monolithic multilayer construction comprising a stack of at least two ceramic layers with electrode layers that are interposed between pairs of ceramic layers.

25. A piezoelectric motor according to one of the previous claims, **characterized in that** the surfaces (5, 6) of the resonator are the external electrodes of the piezoelectric element respectively.

26. A piezoelectric motor according to one of the previous claims, **characterized in that** the piezoelectric element is press-fit into the resonator in a manner that the resonator is deformed elastically and plastically.

27. A piezoelectric motor according to claim 26, **characterized in that** the equivalent voltages stressed in the resonator at the contact region is interlinking it with the piezoelectric element is > 100 N/mm², preferably > 250 N/mm² and particularly preferred > 300 N/mm².

28. A method for manufacturing a piezoelectric motor according to one of the previous claims, **characterized in that** the piezoelectric element is polarized only after its installation into the resonator.

29. A method for manufacturing a piezoelectric motor according to one of the previous claims, **characterized in that** the piezoelectric element is depolarized prior to its installation into the resonator.

30. A method for manufacturing a piezoelectric motor according to one of the previous claims, **characterized in that** the piezoelectric element is in a short circuit during at least its installation into the resonator.

31. A method for manufacturing a piezoelectric motor according to claims 1 - 26, **characterized in that** the piezoelectric element is polarized prior to its installation into the resonator and then is charged with an electrical voltage that is negative in comparison to the polarization.

## Revendications

1. Piézomoteur avec au moins un piézo-élément (1) et au moins un résonateur (2), dans lequel le formage du piézo-élément s'effectue à l'état brut, et ses surfaces (3, 4) ne sont plus lissées après le frittage, **caractérisé en ce qu'**au moins deux surfaces (3, 4) du piézo-élément (1) et au moins deux surfaces (5, 6) du résonateur (2) sont reliées chaque fois directement entre elles sans charges supplémentaires.

2. Piézomoteur selon la revendication 1, **caractérisé en ce que** le piézo-élément est fabriqué d'après le processus de fabrication des condensateurs céramiques.

3. Piézomoteur selon l'une quelconque des revendications précédentes, **caractérisé en ce que** la liaison entre les surfaces (3, 4) et les surfaces (5, 6) n'est qu'en partie à force ou par complémentarité de formes.

4. Piézomoteur selon l'une quelconque des revendications précédentes, **caractérisé en ce que** la liaison entre les surfaces (3, 4) et les surfaces (5, 6) n'est qu'en partie par adhérence de matière.

5. Piézomoteur selon l'une quelconque des revendications précédentes, **caractérisé en ce que** les surfaces (3, 4) présentent des défauts de planéité supérieurs à 1 µm, de préférence supérieurs à 10 µm, de manière particulièrement préférée supérieurs à 100 µm.

6. Piézomoteur selon l'une quelconque des revendications précédentes, **caractérisé en ce que** le piézo-élément (1) est sensiblement en forme de plaque, de cylindre ou de parallélépipède et au moins deux faces opposées du piézo-élément sont des surfaces planes qui ne sont pas exactement parallèles l'une à l'autre.

7. Piézomoteur selon l'une quelconque des revendications précédentes, **caractérisé en ce que** le piézo-élément (1) est mis en une certaine oscillation et transmet cette oscillation au résonateur, **caractérisé en ce que** l'écart standard de la fréquence de résonance choisie pour le fonctionnement est inférieur à 20 %, de préférence inférieur à 5 %, de manière particulièrement préférée inférieur à 1,5 % et de manière tout particulièrement préférée inférieur à 0,6 % et au mieux de préférence inférieur à 0,1 % par rapport à la fréquence de résonance moyenne choisie pour le fonctionnement.

8. Piézomoteur selon l'une quelconque des revendications précédentes, **caractérisé en ce que** le piézo-élément (1) est mis en une certaine oscillation et transmet cette oscillation au résonateur, **caractérisé en ce que** l'écart standard de l'amplitude résultante du résonateur est inférieur à 60 %, de préférence inférieur à 40 %, de manière particulièrement préférée inférieur à 15 % et de manière tout particulièrement préférée inférieur à 5 % par rapport à l'amplitude moyenne.

9. Piézomoteur selon l'une quelconque des revendications précédentes, **caractérisé en ce que** la variation maximale de longueur du piézo-élément est inférieure à 10 µm, de préférence inférieure à 2 µm, de manière particulièrement préférée inférieure à 0,5 µm et de manière tout particulièrement préférée inférieure à 0,1 µm.

10. Piézomoteur selon l'une quelconque des revendications précédentes, **caractérisé en ce que** le piézo-élément (1) est construit dans un mode de construction multicouche monolithique, de préférence avec des électrodes en cuivre parallèles.

11. Piézomoteur selon l'une quelconque des revendications précédentes, **caractérisé en ce qu'**il comporte un piézo-élément (1) avec deux bornes pour la transmission d'un signal électrique d'une source d'excitation au piézo-élément (1).

12. Piézomoteur selon la revendication 11, **caractérisé en ce que** le piézo-élément (1) peut être mis en oscillation dans un premier mode par un premier signal électrique transmis au piézo-élément (1), et dans un second mode par un second signal électrique transmis au piézo-élément (1).

13. Piézomoteur selon la revendication 12, **caractérisé en ce que** le signal électrique est un signal sinusoïdal ou rectangulaire, mais pas un signal en dents de scie.

14. Piézomoteur selon l'une quelconque des revendications précédentes, **caractérisé en ce qu'**un élément, déplaçable par le piézomoteur, peut être entraîné dans deux directions dans le cas de deux signaux transmis au piézo-élément (1).

15. Piézomoteur selon la revendication 14, **caractérisé en ce que** l'élément déplaçable peut être entraîné dans deux directions opposées.

16. Piézomoteur selon l'une quelconque des revendications précédentes, **caractérisé en ce que** les surfaces (3, 4) et/ou les surfaces (5, 6) présentent une pente (9).

17. Piézomoteur selon l'une quelconque des revendications précédentes, **caractérisé en ce que** les surfaces (3, 4) et/ou les surfaces (5, 6) présentent au moins un renflement (7).

18. Piézomoteur selon la revendication 17, **caractérisé en ce que** les renflements (7) ne sont pas disposées au milieu.

19. Piézomoteur selon l'une quelconque des revendications précédentes, **caractérisé en ce que** la surface (3, 4) et/ou la surface (5, 6) sont chacune de forme convexe, au moins en partie, de préférence dans la zone dans laquelle le piézo-élément s'applique contre le résonateur.

20. Piézomoteur selon l'une quelconque des revendications précédentes, **caractérisé en ce qu'**il est mis en fonction à proximité de l'une de ses fréquences de résonance et **en ce qu'**avec un seul piézo-élément et avec chaque fois seulement une excitation électrique il est possible de produire deux mouvements du résonateur à deux fréquences différentes.

21. Piézomoteur selon l'une quelconque des revendications précédentes, **caractérisé en ce que** la largeur (8) des surfaces (3, 4) est supérieure à la largeur (8') des surfaces (5, 6).

22. Piézomoteur selon la revendication 21, **caractérisé en ce que** la largeur (8) des surfaces (3, 4) est supérieure de 1,1 à 10, de préférence de 3 à 5 fois la largeur (8') des surfaces (5,6).

23. Piézomoteur selon l'une quelconque des revendications précédentes, **caractérisé en ce que** le piézo-élément présente des zones d'isolation uniquement dans la région des électrodes extérieures.

24. Piézomoteur selon l'une quelconque des revendications précédentes, **caractérisé en ce que** le piézo-élément est fabriqué dans un mode de construction multicouche monolithique à partir d'une pile d'au moins deux couches céramiques et chaque fois une couche d'électrodes disposée entre deux couches céramiques.

25. Piézomoteur selon l'une quelconque des revendications précédentes, **caractérisé en ce que** les surfaces (5, 6) du résonateur sont dans chaque cas les électrodes extérieures du piézo-élément.

26. Piézomoteur selon l'une quelconque des revendications précédentes, **caractérisé en ce que** le piézo-élément est enfoncé dans le résonateur de manière que le résonateur soit déformé élastiquement et plastiquement.

27. Piézomoteur selon la revendication 26, **caractérisé en ce que** lors de l'enfoncement les tensions comparatives dans le résonateur, dans la zone du contact avec le piézo-élément, sont supérieures à 100 N/mm², de préférence supérieures à 250 N/mm² et de manière tout particulièrement préférée supérieure à 300 N/mm².

28. Procédé de fabrication d'un piézomoteur selon l'une quelconque des revendications précédentes, **caractérisé en ce que** le piézo-élément n'est polarisé qu'après son montage dans le résonateur.

29. Procédé de fabrication d'un piézomoteur selon l'une quelconque des revendications précédentes, **caractérisé en ce que** le piézo-élément est dépolarisé avant son montage dans le résonateur.

30. Procédé de fabrication d'un piézomoteur selon l'une quelconque des revendications précédentes, **caractérisé en ce que** le piézo-élément est court-circuité au moins pendant son montage dans le résonateur.

31. Procédé de fabrication d'un piézomoteur selon l'une quelconque des revendications 1 à 27, **caractérisé en ce que** le piézo-élément est polarisé avant son montage dans le résonateur puis soumis à une tension électrique négative par rapport à la polarisation.
